(19) Europäisches Patentamt
European Patent Office
Office européen des brevets

(11) **EP 2 593 804 B1**

(12) **FASCICULE DE BREVET EUROPEEN**

(45) Date de publication et mention
de la délivrance du brevet:
**08.05.2019 Bulletin 2019/19**

(21) Numéro de dépôt: **11741644.6**

(22) Date de dépôt: **08.07.2011**

(51) Int Cl.:
*G01R 33/3815* (2006.01)     *G01R 33/3875* (2006.01)
*H01F 6/06* (2006.01)

(86) Numéro de dépôt international:
**PCT/FR2011/051629**

(87) Numéro de publication internationale:
**WO 2012/007679 (19.01.2012 Gazette 2012/03)**

(54) **DISPOSITIF D'AIMANT SUPRACONDUCTEUR COMPACT POUR RMN OU IRM**

KOMPAKTE SUPRALEITENDE MAGNETVORRICHTUNG FÜR NMR ODER MRT

COMPACT SUPERCONDUCTING MAGNET DEVICE FOR NMR OR MRI

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.07.2010 FR 1055816**

(43) Date de publication de la demande:
**22.05.2013 Bulletin 2013/21**

(73) Titulaire: **Commissariat à l'Énergie Atomique
et aux Énergies Alternatives
75015 Paris (FR)**

(72) Inventeur: **AUBERT, Guy
F-86000 Poitiers (FR)**

(74) Mandataire: **Desormiere, Pierre-Louis et al
Cabinet Beau de Loménie
158, rue de l'Université
75340 Paris Cedex 07 (FR)**

(56) Documents cités:
**US-A- 4 584 548        US-A- 6 084 497
US-A1- 2009 261 246**

EP 2 593 804 B1

## Description

Domaine de l'invention

La présente invention a pour objet un dispositif d'aimant supraconducteur compact capable de produire un champ magnétique intense et homogène Bz selon un axe Oz dans une zone d'intérêt ZI pouvant présenter un volume important comme par exemple pour des applications de résonance magnétique nucléaire (RMN) ou d'imagerie par résonance magnétique (IRM).

L'invention concerne également un procédé de réalisation d'un tel dispositif d'aimant supraconducteur compact.

Art antérieur

La réalisation d'aimants produisant un champ magnétique très homogène dans un volume important, notamment pour la RMN ou l'IRM, conduit à utiliser des configurations magnétiques spécifiques dont la mise en oeuvre peut s'avérer très délicate. D'où l'idée de rechercher une structure d'aimant simple et facile à réaliser avec précision, comme par exemple un bobinage en couches hélicoïdales suffisamment long pour que les transitions d'une couche à la suivante et les jonctions inévitables entre longueurs successives de conducteurs soient situées assez loin du volume d'intérêt pour ne pas perturber l'homogénéité théorique calculable du bobinage hélicoïdal.

Un bobinage hélicoïdal n'est pas axisymétrique mais le pas de l'hélice est en général suffisamment petit pour que les écarts qui en résultent par rapport à un bobinage théorique axisymétrique soient négligeables. Par ailleurs, il est possible de choisir le nombre de tours par couche et le nombre de couches pour que l'on ait une compensation quasi parfaite de ces écarts. On se limitera donc pour la suite à des configurations purement axisymétriques d'axe $Oz$ également symétriques par rapport à leur plan médian $xOy$. Le développement en harmoniques sphériques (DHS) de la composante $B_z$ du champ dans la zone d'intérêt intérieure (« trou » de l'aimant) prend alors la forme très simple suivante :

$$B_z = Z_0 + \sum_{p=1}^{\infty} Z_{2p} r^{2p} P_{2p}(\cos \vartheta)$$

Ce DHS est valable à l'intérieur de la plus grande sphère de centre $O$ et ne contenant aucun courant ou matériau aimanté.

On montre facilement que les coefficients relatifs $\dfrac{Z_n}{Z_0}$ de ce DHS sont des fonctions décroissantes du rayon minimum $a_1$ du bobinage comme $\dfrac{1}{a_1^n}$. Ainsi, pour réaliser une homogénéité théorique donnée dans une sphère centrée à l'origine de rayon $a < a_1$, il faudra annuler tous les $Z_{2p}$ pour $1 \leq p \leq p_0$. On cherche bien entendu à le faire de la façon la plus économique possible.

Pour des raisons évidentes (installation, utilisation, perturbations extérieures...) on cherche à limiter le champ extérieur généré par l'aimant (« champ de fuite »). La méthode théorique est similaire à celle utilisée pour l'homogénéité mais on utilise le DHS dit extérieur valable à l'extérieur de la plus petite sphère de centre $O$ et ne contenant aucun courant ou matériau aimanté :

$$B_z = \sum_{p=1}^{\infty} M_{2q} \frac{1}{r^{2q+1}} P_{2q}(\cos \vartheta)$$

Les coefficients de ce DHS sont appelés « moments » de la distribution de courant et le premier d'entre eux, $M_2$, est le moment dipolaire.

La première disposition à prendre pour réduire le champ extérieur consiste à annuler le moment dipolaire, ce qui implique la mise en oeuvre de courants tournant autour de $Oz$ en sens inverse de ceux qui produisent le champ dans le volume d'intérêt, ce qui contribue donc à le réduire.

On a déjà proposé, par exemple dans le document US 2009/0261246 A1, une configuration d'aimant supraconducteur comprenant une bobine supraconductrice principale de longueur $L_1$ présentant une symétrie de rotation autour d'un axe z pour créer dans un espace interne un champ magnétique principal et une bobine supraconductrice auxiliaire extérieure coaxiale à la bobine supraconductrice principale, de longueur $L_2$ inférieure à la longueur $L_1$, et présentant une symétrie de rotation autour de l'axe z pour créer dans l'espace interne un champ de direction opposée à celle du champ créé par la bobine supraconductrice principale. La configuration d'aimant supraconducteur comprend en outre des anneaux en matériau ferromagnétique qui sont disposés dans le volume intérieur défini par la bobine supraconductrice principale afin de permettre des compensations et accroître l'homogénéité du champ magnétique dans le volume d'intérêt.

Un tel dispositif permet ainsi d'améliorer l'homogénéité du champ magnétique dans le volume d'intérêt, au prix d'un accroissement du poids dû aux anneaux en matériau ferromagnétique et surtout d'une restriction de l'espace libre dans le volume d'intérêt, puisque les anneaux en matériau ferromagnétique sont disposés à l'intérieur de l'espace libre défini par la bobine supraconductrice principale. Si l'on veut conserver le même espace libre pour le volume d'intérêt, on est ainsi conduit à accroître les dimensions hors tout de l'ensemble du dispositif en augmentant le diamètre des bobines supraconductrices, ce qui nuit à la compacité et augmente le coût de réalisation.

Définition et objet de l'invention

La présente invention vise à remédier aux inconvénients précités et à permettre la réalisation d'un dispositif d'aimant supraconducteur plus compact que les dispositifs existants tout en étant facile à réaliser et qui permette d'obtenir dans un volume d'intérêt un champ magnétique intense et très homogène capable d'être utilisé notamment pour des applications de RMN ou IRM.

Par champ magnétique intense, on entend un champ magnétique au moins égal à 0,5T, de préférence supérieur ou égal à 1T, et qui dans certaines réalisations, peut dépasser 10T.

L'invention vise encore à définir un procédé de réalisation d'un tel dispositif qui soit simplifié et permette néanmoins une optimisation de l'homogénéisation du champ magnétique créé dans le volume d'intérêt.

L'invention est définie par les revendications annexées.

Ces buts sont atteints, conformément à l'invention, grâce à un dispositif d'aimant supraconducteur compact pour générer une composante de champ magnétique homogène Bz selon un axe Oz dans une zone d'intérêt ZI pour des applications de résonance magnétique nucléaire ou d'imagerie par résonance magnétique, comprenant successivement en partant de l'axe Oz et perpendiculairement à cet axe Oz, au moins un premier bobinage hélicoïdal supraconducteur réalisé autour d'une première tranche de cylindre circulaire d'axe Oz délimitée par des premiers cercles d'extrémité, ledit premier bobinage hélicoïdal supraconducteur présentant un premier rayon extérieur $a_{12}$, un premier rayon intérieur $a_{11}$, et une première longueur $2b_1$, avec une première densité de courant azimutale $j_1$, au moins un deuxième bobinage hélicoïdal supraconducteur réalisé autour d'une deuxième tranche de cylindre circulaire d'axe Oz délimitée par des deuxièmes cercles d'extrémité et entourant ladite première tranche de cylindre circulaire, ledit deuxième bobinage présentant un deuxième rayon extérieur $a_{22}$, un deuxième rayon intérieur $a_{21}$, et une deuxième longueur $2b_2$, avec une deuxième densité de courant azimutale $j_2$, caractérisé en ce que les extrémités latérales des premier et deuxième bobinages hélicoïdaux sont disposées, à l'épaisseur des bobinages près, au voisinage d'une même sphère de rayon c dont le centre O est placé sur l'axe Oz au centre de ladite zone d'intérêt ZI et qui englobe l'ensemble du dispositif d'aimant, en ce qu'il comprend en outre au moins un troisième bobinage hélicoïdal supraconducteur réalisé autour d'une troisième tranche de cylindre circulaire d'axe Oz délimitée par des troisièmes cercles d'extrémité et entourant ladite deuxième tranche de cylindre circulaire, ledit troisième bobinage présentant un troisième rayon extérieur $a_{32}$, un troisième rayon intérieur $a_{31}$, et une troisième longueur $2b_3$, avec une troisième densité de courant azimutale $j_3$, en ce que lesdites première, deuxième et troisième densités de courant azimutales $j_1$, $j_2$, $j_3$ présentent alternativement des signes opposés, en ce que les première, deuxième et troisième longueurs $2b_1$, $2b_2$, $2b_3$ des premier, deuxième et troisième bobinages sont décroissantes, en ce que le rayon extérieur $a_{32}$ du bobinage hélicoïdal supraconducteur le plus extérieur est sensiblement égal à la demi-longueur b1 du bobinage hélicoïdal supraconducteur le plus intérieur et en ce que le rayon extérieur $a_{12}$ du bobinage hélicoïdal supraconducteur le plus intérieur est sensiblement égal à la demi-longueur $b_3$ ; $b_4$ du bobinage hélicoïdal supraconducteur le plus extérieur.

Selon un mode particulier de réalisation, le dispositif d'aimant supraconducteur compact comprend en outre au moins un quatrième bobinage hélicoïdal supraconducteur réalisé autour d'une quatrième tranche de cylindre circulaire d'axe Oz délimitée par des quatrièmes cercles d'extrémité et entourant ladite troisième tranche de cylindre circulaire, ledit quatrième bobinage hélicoïdal supraconducteur présentant un quatrième rayon extérieur $a_{42}$, un quatrième rayon intérieur $a_{41}$, et une quatrième longueur $2b_4$, avec une quatrième densité de courant azimutale $j_4$. Les première, deuxième, troisième et quatrième densités de courant azimutales $j_1$, $j_2$, $j_3$, $j_4$ présentent des signes alternativement opposés, et les première, deuxième, troisième et quatrième longueurs $2b_1$, $2b_2$, $2b_3$, $2b_4$ des premier, deuxième, troisième et quatrième bobinages hélicoïdaux supraconducteurs sont décroissantes.

L'invention concerne également un procédé de réalisation d'un dispositif d'aimant supraconducteur compact pour générer une composante de champ magnétique homogène Bz selon un axe Oz dans une zone d'intérêt ZI pour des applications de résonance magnétique nucléaire ou d'imagerie par résonance magnétique, comprenant les étapes suivantes :

a) déterminer une première tranche de cylindre circulaire d'axe Oz délimitée par des premiers cercles d'extrémité et présentant un premier rayon prédéfini a1 et une première longueur prédéfinie $2b_1$ correspondant respectivement au rayon minimum et à la longueur maximum de ladite zone d'intérêt ZI,

b) déterminer une dernière tranche de cylindre circulaire d'axe Oz délimitée par des derniers cercles d'extrémité, entourant ladite première tranche de cylindre circulaire et présentant un dernier rayon prédéfini $a_3$ ; $a_4$ et une dernière longueur prédéfinie $2b_3$; $2b_4$ correspondant respectivement à la longueur maximum $2b_1$ et au rayon minimum $a_1$ de ladite zone d'intérêt ZI,

c) déterminer au moins une tranche de cylindre circulaire intermédiaire d'axe Oz délimitée par des cercles d'extrémité intermédiaires, intercalée entre ladite première tranche de cylindre circulaire et ladite dernière tranche de cylindre circulaire, et présentant un rayon prédéfini intermédiaire $a_2$; $a_3$ compris entre le rayon minimum a1 de ladite zone d'intérêt et le dernier rayon prédéfini $a_3$ ; $a_4$ et une longueur prédéfinie intermédiaire $2b_2$ ; $2b_3$ comprise entre ladite dernière longueur prédéfinie $2b_3$ ; $2b_4$ et ladite longueur maximum $2b_1$, de telle sorte que les premiers cercles d'extrémité, les cercles d'extrémité intermédiaires et les derniers cercles d'extrémité soient situés sur une même sphère de centre O et de rayon c,

d) considérer une première nappe de courant superficielle formée sur la première tranche de cylindre circulaire d'axe Oz, au moins une nappe de courant superficielle intermédiaire formée sur la tranche de cylindre circulaire intermédiaire d'axe Oz et une dernière nappe de courant superficielle mince formée sur la dernière tranche de cylindre circulaire d'axe Oz, les nappes de courant superficielles successives coaxiales présentant chacune une densité superficielle de courant azimutale $\kappa_i$ telle que deux nappes de courant superficielles coaxiales adjacentes présentent des densités superficielles de courant azimutales de signes opposés et déterminer la localisation de la ou des tranches de cylindre circulaire intermédiaire de manière à optimiser l'homogénéité du champ magnétique dans ladite zone d'intérêt ZI,

e) remplacer les nappes de courant superficielles coaxiales successives par des bobinages hélicoïdaux supraconducteurs axisymétriques à demi-section axiale rectangulaire d'épaisseur non nulle tels que les extrémités latérales des bobinages hélicoïdaux soient disposées, à l'épaisseur des bobinages près, au voisinage d'une même sphère de rayon c dont le centre O est placé sur l'axe Oz au centre de ladite zone d'intérêt ZI et qui englobe l'ensemble du dispositif d'aimant.

Selon un mode particulier de réalisation du procédé selon l'invention, à l'étape c) précitée on détermine une unique tranche de cylindre intermédiaire, à l'étape d) précitée on détermine une unique nappe de courant superficielle intermédiaire et à l'étape e) précitée on détermine un unique bobinage hélicoïdal supraconducteur axisymétrique intermédiaire à demi-section axiale rectangulaire d'épaisseur non nulle remplaçant l'unique nappe de courant superficielle intermédiaire.

Selon un autre mode de réalisation particulier du procédé selon l'invention, à l'étape c) précitée on détermine deux tranches de cylindre intermédiaires, à l'étape d) précitée on détermine deux nappes de courant superficielles intermédiaires et à l'étape e) précitée on détermine deux bobinages hélicoïdaux supraconducteurs axisymétriques intermédiaires à demi-section axiale rectangulaire d'épaisseur non nulle remplaçant lesdites deux nappes de courant superficielles intermédiaires.

Brève description des dessins

D'autres caractéristiques et avantages de l'invention ressortiront de la description suivante de modes particuliers de réalisation de l'invention donnés à titre d'exemples en référence aux dessins annexés, sur lesquels :

- La Figure 1 représente une vue schématique d'un dispositif d'aimant selon une étape de réalisation d'un premier mode de réalisation de l'invention avec trois solénoïdes minces,
- La Figure 2 représente une vue schématique d'un dispositif d'aimant selon une étape de réalisation d'un deuxième mode de réalisation de l'invention avec quatre solénoïdes minces,
- La Figure 3 représente une vue schématique d'un dispositif d'aimant selon l'invention avec trois solénoïdes à demi-section axiale rectangulaire d'épaisseur significative,

- La Figure 4A représente le profil du champ magnétique relatif $\dfrac{B_z}{B_0} - 1$ créé par le dispositif de la Figure 1 selon l'axe Oz, et

- La Figure 4B représente le profil du champ magnétique $\dfrac{B_z}{B_0}$ créé par le dispositif de la Figure 1 selon l'axe Oz.

Description détaillée de modes de réalisation préférentiels

Selon l'invention, le procédé d'optimisation de structures d'aimants constituées de bobinages axisymétriques à demi-section axiale rectangulaire comprend une première étape consistant à ne pas prendre en compte l'épaisseur des bobinages. En effet il a été constaté que la prise en compte *ab initio* de l'épaisseur des bobinages alourdit les calculs et ne permet pas d'appréhender facilement les caractéristiques essentielles de la structure.

Selon l'invention, on considère donc, lors d'une première étape, des configurations à base de nappes de courant superficielles portées par des cylindres circulaires d'axe *Oz*. Dans la suite de la description, une telle nappe de courant sera appelée « solénoïde mince » sans autre précision.

Chaque solénoïde mince est caractérisé par son rayon $a$, les cotes $b_1$ et $b_2$ de ses première et deuxième extrémités permettant de définir une longueur 2b ou une demi-longueur b, ainsi que par la densité superficielle de courant azimutale $\kappa$ qu'il porte, mesurée algébriquement autour de *Oz*. On utilisera les notations suivantes :

$$c = \sqrt{a^2 + b^2}$$

$$\sin \alpha = \frac{a}{c}$$

$$\cos \alpha = \frac{b}{c}$$

Les coefficients des développements en harmoniques sphériques (DHS) intérieur et extérieur s'obtiennent par les expressions suivantes :

$$Z_0 = \frac{\mu_0 \kappa}{2} \big[\cos \alpha\big]_{b_1}^{b_2}$$

$$Z_{n \geq 1} = -\frac{\mu_0 \kappa}{2n} \left[\frac{1}{c^n} \sin \alpha\, P_n^1(\cos \alpha)\right]_{b_1}^{b_2}$$

$$M_{n \geq 2} = \frac{\mu_0 \kappa}{2(n+1)} \left[c^{n+1} \sin \alpha\, P_n^1(\cos \alpha)\right]_{b_1}^{b_2}$$

On rappelle que $M_0 = 0$ car les équations de Maxwell ont été écrites de façon à faire disparaître les charges magnétiques en ne laissant subsister que les charges électriques (pas de « monopôle » magnétique). Par ailleurs, l'expression de $M_n$ ci-dessus conduit à $M_1 = 0$ et le premier moment non nul *a priori* est le moment dipolaire, propriété générale pour toute distribution de courant.

Ces expressions révèlent une propriété remarquable. Si l'on considère un ensemble de tels solénoïdes coaxiaux dont les cercles d'extrémités se situent sur une même sphère de rayon c, chaque solénoïde n'est plus caractérisé que par deux paramètres $\alpha_i$ et $\kappa_i$. Cette configuration peut être qualifiée de « circumsphérique ». Pour réaliser un aimant homogène, on choisit ces paramètres pour annuler simultanément les $Z_{2n}$ (les termes de degré impair sont nuls par raison de symétrie par rapport à $xOy$) jusqu'à un degré $2n_0$, les moments $M_{2n}$ seront également tous annulés jusqu'au même degré. En améliorant l'homogénéité, on diminue donc ici concomitamment le champ extérieur.

La mise en oeuvre de deux solénoïdes permet d'annuler $Z_2$ et donc simultanément $M_2$. Selon l'invention, on met en oeuvre des configurations à trois ou quatre solénoïdes qui permettent d'améliorer l'homogénéité sans devoir ajouter des anneaux de fer dans le volume de la zone d'intérêt située à l'intérieur du solénoïde interne.

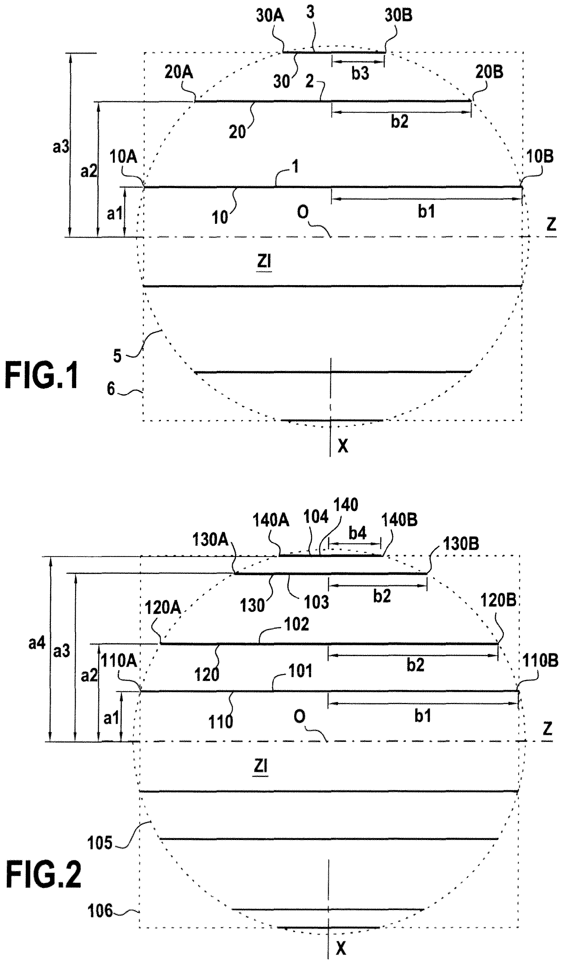

La Figure 1 montre un aimant circumsphérique selon l'invention dans sa configuration à trois solénoïdes minces 1, 2, 3 disposés de façon coaxiale autour de l'axe Oz en allant de l'intérieur vers l'extérieur.

La configuration circumsphérique à trois solénoïdes dépend de 5 paramètres si l'on affecte les indices 1, 2 et 3 respectivement pour chacun des solénoïdes minces:

$$\alpha_1, \alpha_2, \alpha_3$$

$$\frac{\kappa_2}{\kappa_1}, \frac{\kappa_3}{\kappa_1}$$

On peut satisfaire deux (et pas plus !) conditions d'homogénéité :

$$Z_2 = Z_4 = 0$$

qui entraîneront l'annulation du moment dipolaire et du moment quadripolaire.

$\alpha_1$ est fixé *a priori* par le rayon intérieur utile $a_1$ du solénoïde mince 1 qui correspond à une tranche de cylindre circulaire 10 d'axe Oz limitée par des cercles d'extrémité 10A, 10B (c'est-à-dire une portion de cylindre 10 limitée par deux plans perpendiculaires aux génératrices du cylindre) et délimitant une zone d'intérêt ZI devant être libre et soumise à un champ magnétique le plus homogène possible,

$\alpha_3$ est fixé *a priori* par le rayon extérieur < $c$ à ne pas dépasser pour le solénoïde mince 3 le plus externe.

Il reste alors un degré de liberté et donc une possibilité d'optimisation. La grandeur gouvernant celle-ci est le facteur de qualité dont l'expression générale pour une configuration circumsphérique de solénoïdes minces est la suivante :

$$Q = \frac{\sin^2 \alpha_1 \left| \sum_i \kappa_i \cos \alpha_i \right|}{\sum_i |\kappa_i| \sin \alpha_i \cos \alpha_i}$$

Il suffit de maximiser $Q$ en respectant les contraintes susmentionnées pour déterminer complètement la configuration.

Si à titre d'exemple on impose les valeurs suivantes pour les premier et troisième solénoïdes:

$$\begin{aligned} a_1 &= 1\,m \\ b_1 &= 3.7\,m \end{aligned} \rightarrow \alpha_1 = 0.263964$$

$$\alpha_3 = \frac{\pi}{2} - \alpha_1 \rightarrow \begin{aligned} a_3 &= 3.7\,m \\ b_3 &= 1\,m \end{aligned}$$

On constate que l'on a défini un ensemble « carré » 6 dont la longueur $2b_1$ est égale au diamètre extérieur $2a_3$ du troisième solénoïde 3.

La solution optimale est alors déduite pour le deuxième solénoïde intermédiaire 2 et pour cet exemple se trouve la suivante :

$$\alpha_2 = 0.790145 \rightarrow \begin{array}{l} a_2 = 2.723001 \, m \\ b_2 = 2.697270 \, m \end{array}$$

$$\frac{\kappa_2}{\kappa_1} = -0.259402$$

$$\frac{\kappa_3}{\kappa_1} = 0.108687$$

$$B_0 = 0.811169 \, \mu_0 \kappa_1$$

$$Q = 0.135029$$

Sur la figure 1, les trois solénoïdes 1, 2, 3 définis chacun par une tranche de cylindre 10, 20, 30 respectivement limitée par des cercles d'extrémité 10A, 10B, 20A, 20B, 30A, 30B situés essentiellement sur une sphère 5 de rayon c, présentent des densités superficielles de courant azimutales qui présentent alternativement des signes opposés. Ainsi, par exemple on a pour les solénoïdes 1 et 3 une densité superficielle de courant azimutale $\kappa$>0 tandis que l'on a pour le solénoïde intermédiaire 2 une densité superficielle de courant azimutale $\kappa$<0.

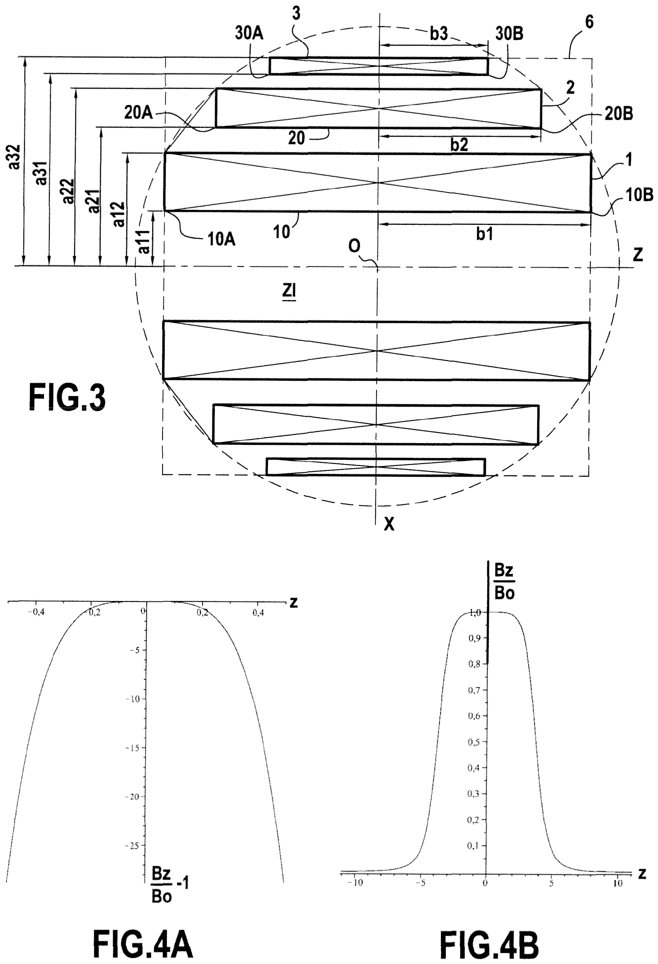

Les courbes des figures 4A et 4B montrent l'homogénéité obtenue :

$$\frac{B_z}{B_0} - 1$$

La courbe de la Figure 4A représente le profil de champ relatif $\frac{B_z}{B_0} - 1$ sur l'axe Oz en *ppm* et celle de la Figure 4B

$$\frac{B_z}{B_0}$$

représente le profil de champ $\frac{B_z}{B_0}$ également sur l'axe Oz où $B_z$ représente l'intensité du champ selon l'axe Oz.

On décrira maintenant en référence à la Figure 2 un aimant circumsphérique selon l'invention dans sa configuration à quatre solénoïdes minces 101, 102, 103, 104 disposés de façon coaxiale autour de l'axe Oz en allant de l'intérieur vers l'extérieur.

La configuration circumsphérique à quatre solénoïdes dépend de 7 paramètres si l'on affecte les indices 101, 102, 103 et 104 respectivement pour chacun des solénoïdes minces:

$$\alpha_1, \alpha_2, \alpha_3, \alpha_4$$

$$\frac{\kappa_2}{\kappa_1}, \frac{\kappa_3}{\kappa_1}, \frac{\kappa_4}{\kappa_1}$$

On peut satisfaire trois (et pas plus !) conditions d'homogénéité :

$$Z_2 = Z_4 = Z_6 = 0$$

qui entraîneront l'annulation du moment dipolaire, du moment quadripolaire et du moment hexapolaire.

$\alpha_1$ est fixé *a priori* par le rayon intérieur utile $a_1$ du solénoïde mince 101 qui correspond à une tranche de cylindre circulaire 110 d'axe Oz limitée par des cercles d'extrémité 110A, 110B et délimitant une zone d'intérêt ZI devant être libre et soumise à un champ magnétique le plus homogène possible,

$\alpha_3$ est fixé *a priori* par le rayon extérieur < *c* à ne pas dépasser pour le solénoïde mince le plus externe 104.

Il reste alors deux degrés de liberté qui seront déterminés de façon unique en maximisant le facteur de qualité Q.

Avec la même forme « carrée » et les mêmes valeurs d'un volume 106 à section carrée que pour l'exemple précédent, on trouve :

$$\begin{aligned} a_1 &= 1\,m \\ b_1 &= 3.7\,m \end{aligned} \rightarrow \alpha_1 = 0.263964$$

$$\alpha_4 = \frac{\pi}{2} - \alpha_1 \rightarrow \begin{aligned} a_4 &= 3.7\,m \\ b_4 &= 1\,m \end{aligned}$$

$$\alpha_2 = 0.530326 \rightarrow \begin{aligned} a_2 &= 1.938663\,m \\ b_2 &= 3.306295\,m \end{aligned}$$

$$\alpha_3 = 1.058012 \rightarrow \begin{aligned} a_3 &= 3.339793\,m \\ b_3 &= 1.880369\,m \end{aligned}$$

$$\frac{\kappa_2}{\kappa_1} = -0.459351$$

$$\frac{\kappa_3}{\kappa_1} = 0.150085$$

$$\frac{\kappa_4}{\kappa_1} = -0.0832578$$

$$B_0 = 0.621018\,\mu_0\kappa_1$$

$$Q = 0.078660$$

Sur la figure 2, les quatre solénoïdes 101, 102, 103, 104 définis chacun par une tranche de cylindre 110, 120, 130, 140 respectivement limitée par des cercles d'extrémité 110A, 110B, 120A, 120B, 130A, 130B, 140A, 140B situés essentiellement sur une sphère 105 de rayon c, présentent des densités superficielles de courant azimutales qui présentent alternativement des signes opposés. Ainsi, par exemple on a pour les solénoïdes 101 et 103 une densité superficielle de courant azimutale $\kappa > 0$ tandis que l'on a pour le solénoïde intermédiaire 102 et le dernier solénoïde 104 une densité superficielle de courant azimutale $\kappa < 0$.

Avec la configuration de la Figure 2, on a une diminution du coefficient de champ et du facteur de qualité. Des courbes analogues à celles des Figures 4A et 4B montrent que l'homogénéité est nettement améliorée alors que l'annulation d'un moment supplémentaire ne modifie pas de façon aussi sensible la décroissance du champ extérieur qui était déjà très marquée.

On remarque que l'homogénéité est bien meilleure que celle que l'on obtiendrait avec une configuration classique à quatre solénoïdes de même rayon et de même longueur totale dont les cotes seraient les suivantes (on notera que les trois intervalles vides sont très étroits) :

$$a = 1\,m$$

$$b_1 = \pm 3.7 \, m$$

$$b_2 = \pm 0.508629 \, m$$

$$b_3 = \pm 0.497528 \, m$$

$$b_4 = \pm 0.00453561 \, m$$

$$B_0 = 0.952914 \, \mu_0 \kappa$$

$$Q = 0.258637$$

L'homogénéité de la configuration circumsphérique de la Figure 2 avec des solénoïdes coaxiaux de rayons croissants $a_1$, $a_2$, $a_3$, $a_4$, est bien meilleure que celle d'une configuration classique à quatre solénoïdes de même rayon $a=a_1$, car les courants en sens inverse qui permettent l'annulation de $Z_2$, $Z_4$ et $Z_6$ conduisent à une réduction très significative des coefficients suivants, ce qui ne se produit pas pour la configuration classique.

Selon l'invention, après avoir déterminé la configuration souhaitée avec trois ou quatre solénoïdes minces comme indiqué précédemment en référence aux Figures 1 et 2, on remplace les nappes de courant superficielles coaxiales successives par des bobinages hélicoïdaux supraconducteurs axisymétriques à demi-section axiale rectangulaire d'épaisseur non nulle 1, 2, 3 ou 101, 102, 103, 104 tels que les extrémités latérales des bobinages hélicoïdaux 1, 2, 3 ou 101, 102, 103, 104 restent disposées au voisinage d'une même sphère 5 ou 105 de rayon c dont le centre O est placé sur l'axe Oz au centre de la zone d'intérêt ZI et qui englobe l'ensemble du dispositif d'aimant.

On obtient ainsi un dispositif d'aimant circumsphérique réel avec des bobines d'épaisseur finie. Le passage des solutions idéales précédentes déterminées lors d'une première étape à des configurations réelles est alors à ce stade très simple. Il suffit de remplacer les solénoïdes minces par des bobinages à demi-section axiale rectangulaire dont l'épaisseur est maintenant finie.

On retrouve ici un problème d'optimisation classique dans lequel on fixe des paramètres géométriques (rayon intérieur de bobinage $a_{11}$, rayon extérieur maximum $a_{32}$, longueur totale maximum $2b_1$) et les densités de courant hors tout pour les bobines, avec ou sans gradation. Les données géométriques obtenues pour les configurations idéales à même nombre de bobines fournissent les valeurs de départ nécessaires, en particulier les épaisseurs $e_i$ des bobinages réels à densité de courant $j_i$ avec $j_i e_i \approx \kappa_i$.

On a représenté sur la Figure 3 un exemple de dispositif d'aimant supraconducteur selon l'invention avec trois bobines réelles 1, 2, 3 formées autour de tranches de cylindres respectivement 10, 20, 30 limitées par des cercles d'extrémité 10A, 10B, 20A, 20B, 30A, 30B, les trois bobines réelles 1, 2, 3 à demi-section axiale rectangulaire présentant respectivement une demi-longueur $b_1$, $b_2$, $b_3$, un rayon extérieur $a_{12}$, $a_{22}$, $a_{32}$ et un rayon intérieur $a_{11}$, $a_{21}$, $a_{31}$. Les bobines réelles 1, 2, 3 ont des densités volumiques de courant azimutales $j_1$, $j_2$, $j_3$ qui présentent alternativement des signes opposés.

On donne ci-dessous à titre d'exemple des valeurs numériques pour une configuration circumsphérique à trois bobines permettant d'obtenir un champ magnétique intense et homogène avec un encombrement moindre que les dispositifs connus déjà proposés pour créer de telles valeurs de champ magnétique dans un volume utile d'une zone d'intérêt ZI de rayon 0.5m. On définit ici un rayon extérieur et une demi-longueur de 1.85m.

Les valeurs du rayon interne $a_1$, du rayon externe $a_2$, de la demi-longueur b et de la densité de courant azimutale j sont données ci-dessous successivement pour chacun des bobinages 1, 2, 3 :

| $a_1$ (m) | $a_2$ (m) | b (m) | j (A/mm²) |
|---|---|---|---|
| 0.5 | 0.993841 | 1.85 | 35 |
| 1.238087 | 1.570660 | 1.445131 | -42 |
| 1.705922 | 1.85 | 0.963238 | 49 |

$$B_0 = 11.7436 \, T$$

$$V_S = 20.158\,m^3$$

$$Z_2 = Z_4 = 0$$

$$M_2 = M_4 = 0$$

Six paramètres sont fixés à l'avance, à savoir le rayon interne $a_1$ (encore noté $a_{11}$) de la bobine 1, le rayon externe $a_2$ (encore noté $a_{32}$) de la bobine 3, la demi-longueur b (encore notée $b_1$) de la bobine 1 et les densités de courant azimutales j des trois bobines 1 à 3 (avec pour la bobine intermédiaire 2 un signe contraire de celui des deux autres bobines 1 et 3) et les 6 autres paramètres figurant sur le tableau résultent de l'optimisation.

On a tracé en pointillé sur la Figure 3 la trace de la plus petite sphère 5 ainsi que celle (carrée) du plus petit cylindre 6 englobant l'aimant.

Comme on n'a annulé rigoureusement que les deux premiers coefficients du DHS intérieur, on pourrait s'attendre à ce que cet aimant ne soit pas très homogène. Il n'en est pourtant rien et l'homogénéité est très satisfaisante. On a en effet :

$$Z_6 = -0.019\,ppm\,@\,r_0 = 0.11\,m$$

et tous les autres coefficients inférieurs au *ppb*. Si l'on prend $r_0$ = 0.2 *m* pour mieux révéler les coefficients non nuls, on trouve que les seuls supérieurs au *ppb* sont :

$$Z_6 = -0.697\,ppm$$

$$Z_8 = -0.005\,ppm$$

La limitation du champ extérieur est également excellente puisque la ligne des 5 *gauss* se situe à 7.95 *m* sur l'axe et à 6.645 *m* dans le plan perpendiculaire.

Un dispositif d'aimant réel à quatre bobines essentiellement axisymétriques à demi-section axiale rectangulaire est réalisé selon le même processus à partir de la configuration idéale déterminée avec des configurations à base de nappes de courant superficielles portées par des cylindres circulaires d'axe Oz telles que celles représentées sur la Figure 2.

Selon l'invention, on part d'un ensemble de solénoïdes minces, afin de pouvoir résoudre simultanément et de façon automatique le problème de l'homogénéité et de la réduction du champ de fuite, la condition imposée étant alors simple et résidant dans la nécessité que les cercles d'extrémité des solénoïdes minces soient situés sensiblement sur la même sphère. Un solénoïde mince étant un idéal théorique alors que dans un bobinage réel, il faut bien une certaine épaisseur pour faire passer le courant, même dans un supraconducteur, selon l'invention, on fait évoluer la solution obtenue avec des solénoïdes minces en les rendant plus épais, par un processus d'optimisation comme indiqué plus haut. Dans ces conditions, aucun des cercles d'extrémité des solénoïdes épais (celui du rayon intérieur et celui du rayon extérieur) ne peut plus se trouver rigoureusement sur la même sphère, mais ces cercles d'extrémité restent au voisinage d'une sphère correspondant au cas idéal avec solénoïdes minces, le voisinage des cercles d'extrémité par rapport à la sphère étant d'autant plus proche que les solénoïdes sont moins épais. Par contre, malgré ce voisinage moins proche, on peut conserver pour l'ensemble de solénoïdes épais réels, les mêmes propriétés d'homogénéité et de champ de fuite que celles que l'on avait pour l'ensemble de solénoïdes minces, en choisissant convenablement les rayons intérieur et extérieur (qui encadrent le rayon du solénoïde mince correspondant) et les longueurs (chacune étant également voisine de celle du solénoïde mince correspondant), le tout restant globalement inscrit approximativement dans une sphère.

Le dispositif d'aimant supraconducteur selon l'invention peut être mis en oeuvre quelle que soit la valeur de champ souhaitée. Il peut en particulier être utilisé pour l'obtention d'une composante de champ magnétique homogène Bz intense par exemple égale à 10 ou 11 teslas.

En résumé, le dispositif d'aimant supraconducteur compact pour générer une composante de champ magnétique intense et homogène Bz selon un axe Oz dans une zone d'intérêt ZI, comprend successivement en partant de l'axe Oz, au moins trois bobinages 1, 2, 3 hélicoïdaux supraconducteurs coaxiaux réalisés autour de tranches de

cylindre circulaire 10, 20, 30 d'axe Oz délimitées par des cercles d'extrémité 10A, 10B, 20A, 20B, 30A, 30B. Les extrémités latérales des bobinages hélicoïdaux 1, 2, 3 (ou 101 à 104) sont disposées, à l'épaisseur des bobinages près, au voisinage d'une même sphère 5 (ou 105) de rayon c dont le centre O est placé sur l'axe Oz au centre de la zone d'intérêt ZI et qui englobe l'ensemble du dispositif d'aimant. Les densités de courant azimutales $j_1$, $j_2$, $j_3$ des bobinages hélicoïdaux 1, 2, 3 (ou 101 à 104) présentent alternativement des signes opposés. Les longueurs $2b_1$, $2b_2$, $2b_3$ (et le cas échéant $2b_4$) des bobinages hélicoïdaux 1, 2, 3 (ou 101 à 104) sont décroissantes. Le rayon extérieur $a_{32}$ du bobinage hélicoïdal supraconducteur le plus extérieur 3 (ou 104) est sensiblement égal à la demi-longueur $b_1$ du bobinage hélicoïdal supraconducteur le plus intérieur 1 (ou 101) et le rayon extérieur $a_{12}$ du bobinage hélicoïdal supraconducteur le plus intérieur 1 (ou 101) est sensiblement égal à la demi-longueur $b_3$ (ou $b_4$) du bobinage hélicoïdal supraconducteur le plus extérieur 3 (ou 104).

## Revendications

1. Dispositif d'aimant supraconducteur compact pour générer une composante de champ magnétique homogène Bz selon un axe Oz dans une zone d'intérêt (ZI) pour des applications de résonance magnétique nucléaire ou d'imagerie par résonance magnétique, comprenant successivement en partant de l'axe Oz et perpendiculairement à cet axe Oz, au moins un premier bobinage (1 ; 101) hélicoïdal supraconducteur réalisé autour d'une première tranche de cylindre circulaire (10 ; 110) d'axe Oz délimitée par des premiers cercles d'extrémité (10A, 10B ; 110A, 110B), ledit premier bobinage (1 ; 101) hélicoïdal supraconducteur présentant un premier rayon extérieur ($a_{12}$), un premier rayon intérieur ($a_{11}$), et une première longueur ($2b_1$), avec une première densité de courant azimutale $j_1$, au moins un deuxième bobinage (2 ; 102) hélicoïdal supraconducteur réalisé autour d'une deuxième tranche de cylindre circulaire (20 ; 120) d'axe Oz délimitée par des deuxièmes cercles d'extrémité (20A, 20B ; 120A, 120B) et entourant ladite première tranche de cylindre circulaire (10 ; 110), ledit deuxième bobinage (2 ; 102) présentant un deuxième rayon extérieur ($a_{22}$), un deuxième rayon intérieur ($a_{21}$), et une deuxième longueur ($2b_2$), avec une deuxième densité de courant azimutale $j_2$, **caractérisé en ce que** les extrémités latérales des premier et deuxième bobinages hélicoïdaux (1, 2 ; 101, 102) sont disposées, à l'épaisseur des bobinages près, au voisinage d'une même sphère (5 ; 105) de rayon c dont le centre O est placé sur l'axe Oz au centre de ladite zone d'intérêt (ZI) et qui englobe l'ensemble du dispositif d'aimant, **en ce qu'**il comprend en outre au moins un troisième bobinage (3 ; 103) hélicoïdal supraconducteur réalisé autour d'une troisième tranche de cylindre circulaire (30 ; 130) d'axe Oz délimitée par des troisièmes cercles d'extrémité (30A, 30B ; 130A, 130B) et entourant ladite deuxième tranche de cylindre circulaire (20 ; 120), ledit troisième bobinage (3 ; 103) présentant un troisième rayon extérieur ($a_{32}$), un troisième rayon intérieur ($a_{31}$), et une troisième longueur ($2b_3$), avec une troisième densité de courant azimutale $j_3$, **en ce que** lesdites première, deuxième et troisième densités de courant azimutales $j_1$, $j_2$, $j_3$ présentent alternativement des signes opposés, **en ce que** les première, deuxième et troisième longueurs ($2b_1$, $2b_2$, $2b_3$) des premier, deuxième et troisième bobinages (1, 2, 3 ; 101, 102, 103) sont décroissantes, **en ce que** le rayon extérieur ($a_{32}$) du bobinage hélicoïdal supraconducteur le plus extérieur (3 ; 104) est sensiblement égal à la demi-longueur ($b_1$) du bobinage hélicoïdal supraconducteur le plus intérieur (1 ; 101) et **en ce que** le rayon extérieur ($a_{12}$) du bobinage hélicoïdal supraconducteur le plus intérieur (1 ; 101) est sensiblement égal à la demi-longueur ($b_3$ ; $b_4$) du bobinage hélicoïdal supraconducteur le plus extérieur (3 ; 104), l'extrémité latérale du troisième bobinage (3 ; 103) étant disposée, à l'épaisseur du bobinage près, au voisinage de la même sphère (5 ; 105) que celle définie pour les extrémités latérales desdits premier et deuxième bobinages (1, 2 ; 101, 102).

2. Dispositif d'aimant supraconducteur selon la revendication 1, **caractérisé en ce qu'**il comprend en outre au moins un quatrième bobinage (104) hélicoïdal supraconducteur réalisé autour d'une quatrième tranche de cylindre circulaire (140) d'axe Oz délimitée par des quatrièmes cercles d'extrémité (140A, 140B) et entourant ladite troisième tranche de cylindre circulaire (130), ledit quatrième bobinage (104) hélicoïdal supraconducteur présentant un quatrième rayon extérieur ($a_{42}$), un quatrième rayon intérieur ($a_{41}$), et une quatrième longueur ($2b_4$), avec une quatrième densité de courant azimutale $j_4$, **en ce que** les première, deuxième, troisième et quatrième densités de courant azimutales $j_1$, $j_2$, $j_3$, $j_4$ présentent des signes alternativement opposés, et **en ce que** les première, deuxième, troisième et quatrième longueurs ($2b_1$, $2b_2$, $2b_3$, $2b_4$) des premier, deuxième, troisième et quatrième bobinages (101, 102, 103, 104) hélicoïdaux supraconducteurs sont décroissantes, l'extrémité latérale du quatrième bobinage (104) étant disposée, à l'épaisseur du bobinage près, au voisinage de la même sphère (105) que celle définie pour les extrémités latérales desdits premier et deuxième bobinages (101, 102).

3. Procédé de réalisation d'un dispositif d'aimant supraconducteur compact pour générer une composante de champ magnétique homogène Bz selon un axe Oz dans une zone d'intérêt ZI pour des applications de résonance magnétique nucléaire ou d'imagerie par résonance magnétique, comprenant les étapes suivantes :

a) déterminer une première tranche de cylindre circulaire (10 ; 110) d'axe Oz délimitée par des premiers cercles d'extrémité (10A, 10B ; 110A, 110B) et présentant un premier rayon prédéfini ($a_1$) et une première longueur prédéfinie ($2b_1$) correspondant respectivement au rayon minimum et à la longueur maximum de ladite zone d'intérêt ZI,

b) déterminer une dernière tranche de cylindre circulaire (30 ; 140) d'axe Oz délimitée par des derniers cercles d'extrémité (30A, 30B ; 140A, 140B), entourant ladite première tranche de cylindre circulaire (10 ; 110) et présentant un dernier rayon prédéfini ($a_3$ ; $a_4$) et une dernière longueur prédéfinie ($2b_3$ ; $2b_4$) correspondant respectivement à la longueur maximum ($2b_1$) et au rayon minimum ($a_1$) de ladite zone d'intérêt ZI,

c) déterminer au moins une tranche de cylindre circulaire intermédiaire (20 ; 120, 130) d'axe Oz délimitée par des cercles d'extrémité intermédiaires (20A, 20B ; 120A, 120B, 130A, 130B), intercalée entre ladite première tranche de cylindre circulaire (10 ; 110) et ladite dernière tranche de cylindre circulaire (30 ; 140), et présentant un rayon prédéfini intermédiaire ($a_2$ ; $a_3$) compris entre le rayon minimum ($a_1$) de ladite zone d'intérêt et le dernier rayon prédéfini ($a_3$ ; $a_4$) et une longueur prédéfinie intermédiaire ($2b_2$ ; $2b_3$) comprise entre ladite dernière longueur prédéfinie ($2b_3$ ; $2b_4$) et ladite longueur maximum ($2b_1$), de telle sorte que les premiers cercles d'extrémité (10A, 10B ; 110A, 110B), les cercles d'extrémité intermédiaires (20A, 20B ; 120A, 120B, 130A, 130B) et les derniers cercles d'extrémité (30A, 30B ; 140A, 140B) soient situés sur une même sphère de centre O et de rayon c,

d) considérer une première nappe de courant superficielle formée sur la première tranche de cylindre circulaire (10 ; 110) d'axe Oz, au moins une nappe de courant superficielle intermédiaire formée sur la tranche de cylindre circulaire intermédiaire (20 ; 120, 130) d'axe Oz et une dernière nappe de courant superficielle mince formée sur la dernière tranche de cylindre circulaire (30 ; 140) d'axe Oz, les nappes de courant superficielles successives coaxiales présentant chacune une densité superficielle de courant azimutale $\kappa_i$ telle que deux nappes de courant superficielles coaxiales adjacentes présentent des densités superficielles de courant azimutales de signes opposés et déterminer la localisation de la ou des tranches de cylindre circulaire intermédiaire (20 ; 120, 130) de manière à optimiser l'homogénéité du champ magnétique dans ladite zone d'intérêt ZI,

e) remplacer les nappes de courant superficielles coaxiales successives par des bobinages hélicoïdaux supraconducteurs axisymétriques à demi-section axiale rectangulaire d'épaisseur non nulle (1, 2, 3 ; 101, 102, 103, 104) tels que les extrémités latérales des bobinages hélicoïdaux (1, 2, 3 ; 101, 102, 103, 104) soient disposées, à l'épaisseur des bobinages près, au voisinage d'une même sphère (5 ; 105) de rayon c dont le centre O est placé sur l'axe Oz au centre de ladite zone d'intérêt ZI et qui englobe l'ensemble du dispositif d'aimant.

4. Procédé selon la revendication 3, **caractérisé en ce que** à l'étape c) précitée on détermine une unique tranche de cylindre intermédiaire (20), à l'étape d) précitée on détermine une unique nappe de courant superficielle intermédiaire et à l'étape e) précitée on détermine un unique bobinage hélicoïdal supraconducteur axisymétrique intermédiaire (2) à demi-section axiale rectangulaire d'épaisseur non nulle remplaçant l'unique nappe de courant superficielle intermédiaire.

5. Procédé selon la revendication 3, **caractérisé en ce que** à l'étape c) précitée on détermine deux tranches de cylindre intermédiaires (120, 130), à l'étape d) précitée on détermine deux nappes de courant superficielles intermédiaires et à l'étape e) précitée on détermine deux bobinages hélicoïdaux supraconducteurs axisymétriques intermédiaires (102, 103) à demi-section axiale rectangulaire d'épaisseur non nulle remplaçant lesdites deux nappes de courant superficielles intermédiaires.

**Patentansprüche**

1. Kompakte supraleitende Magnetvorrichtung zum Erzeugen einer homogenen Magnetfeldkomponente Bz gemäß einer Oz-Achse in einem interessierenden Bereich (ZI) für Anwendungen der Kernspinresonanz oder der Magnetresonanztomographie, umfassend nacheinander, ausgehend von der Oz-Achse und senkrecht zu dieser Oz-Achse, mindestens eine erste schraubenförmige supraleitende Wicklung (1; 101), die um eine erste Kreiszylinderscheibe (10; 110) der Oz-Achse umgesetzt wird, die durch erste Endkreise (10A, 10B; 110A, 110B) begrenzt ist, wobei die erste schraubenförmige supraleitende Wicklung (1; 101) einen ersten Außenradius ($a_{12}$), einen ersten Innenradius ($a_{11}$) und eine erste Länge ($2b_1$) mit einer ersten Dichte $j_1$ der azimutalen Strömung aufweist, mindestens eine zweite schraubenförmige supraleitende Wicklung (2; 102), die um eine zweite Kreiszylinderscheibe (20; 120) der Oz-Achse umgesetzt wird, die durch zweite Endkreise (20A, 20B; 120A, 120B) begrenzt ist und die erste Kreiszylinderscheibe (10; 110) umgibt, wobei die zweite Wicklung (2; 102) einen zweiten Außenradius ($a_{22}$), einen zweiten Innenradius ($a_{21}$) und eine zweite Länge ($2b_2$) mit einer zweiten Dichte $j_2$ der azimutalen Strömung aufweist, **dadurch gekennzeichnet, dass** die seitlichen Enden der ersten und zweiten schraubenförmigen Wicklung (1, 2; 101; 102), bis auf die Dicke der Wicklungen, in der Nähe derselben Kugel (5; 105) mit einem Radius c angeordnet sind, deren Mittelpunkt O auf der Oz-Achse im Mittelpunkt des interessierenden Bereichs (ZI) platziert ist und welche die gesamte Magnetvorrichtung umgibt, dadurch, dass sie zudem mindestens eine dritte schraubenförmige supraleitende Wicklung (3; 103) umfasst, die um eine dritte Kreiszylinderscheibe (30; 130) der Oz-Achse umgesetzt wird, die durch dritte Endkreise (30A, 30B; 130A, 130B) begrenzt ist und die zweite Kreiszylinderscheibe (20; 120) umgibt, wobei die dritte Wicklung (3; 103) einen dritten Außenradius ($a_{32}$), einen dritten Innenradius ($a_{31}$) und eine dritte Länge ($2b_3$) mit einer dritten Dichte $j_3$ der azimutalen Strömung aufweist, dadurch, dass die erste, zweite und dritte Dichte $j_1$, $j_2$, $j_3$ der azimutalen Strömung abwechselnd entgegengesetzte Vorzeichen aufweisen, dadurch, dass die erste, zweite und dritte Länge ($2b_1$; $2b_2$; $2b_3$) der ersten, zweiten und dritten Wicklung (1, 2, 3; 101; 102, 103) abnehmend sind, dadurch, dass der Außenradius ($a_{32}$) der äußersten schraubenförmigen supraleitenden Wicklung (3; 104) im Wesentlichen der halben Länge ($b_1$) der innersten schraubenförmigen supraleitenden Wicklung (1; 101) entspricht und dadurch, dass der Außenradius ($a_{12}$) der innersten schraubenförmigen supraleitenden Wicklung (1; 101) im Wesentlichen der halben Länge ($b_3$; $b_4$) der äußersten schraubenförmigen supraleitenden Wicklung (3; 104) entspricht, wobei das seitliche Ende der dritten Wicklung (3; 103), bis auf die Dicke der Wicklung, in der Nähe derselben Kugel (5; 105) angeordnet ist, wie der, die für die seitlichen Enden der ersten und zweiten schraubenförmigen Wicklung (1, 2; 101; 102) definiert ist.

2. Supraleitende Magnetvorrichtung nach Anspruch 1, **dadurch gekennzeichnet, dass** sie zudem mindestens eine vierte schraubenförmige supraleitende Wicklung (104) umfasst, die um eine vierte Kreiszylinderscheibe (140) der Oz-Achse umgesetzt wird, die durch vierte Endkreise (140A, 140B) begrenzt ist und die dritte Kreiszylinderscheibe (130) umgibt, wobei die vierte schraubenförmige supraleitende Wicklung (104) einen vierten Außenradius ($a_{42}$), einen vierten Innenradius ($a_{41}$) und eine vierte Länge ($2b_4$) mit einer vierten Dichte $j_4$ der azimutalen Strömung aufweist, dadurch, dass die erste, zweite, dritte und vierte Dichte $j_1$, $j_2$, $j_3$, $j_4$ der azimutalen Strömung abwechselnd entgegengesetzte Vorzeichen aufweisen, und dadurch, dass die erste, zweite, dritte und vierte Länge ($2b_1$; $2b_2$; $2b_3$; $2b_4$) der ersten, zweiten, dritten und vierten schraubenförmigen supraleitenden Wicklung (101, 102, 103, 104) abnehmend sind, wobei das seitliche Ende der vierten Wicklung (104), bis auf die Dicke der Wicklung, in der Nähe derselben Kugel (105) angeordnet ist, wie der, die für die seitlichen Enden der ersten und zweiten Wicklung (101; 102) definiert ist.

3. Verfahren zur Umsetzung einer kompakten supraleitenden Magnetvorrichtung zum Erzeugen einer homogenen Magnetfeldkomponente Bz gemäß einer Oz-Achse in einem interessierenden Bereich ZI für Anwendungen der Kernspinresonanz oder der Magnetresonanztomographie, umfassend die folgenden Schritte:

a) Bestimmen einer ersten Kreiszylinderscheibe (10; 110) der Oz-Achse, die durch erste Endkreise (10A, 10B; 110A, 110B) begrenzt ist und einen ersten vordefinierten Radius ($a_1$) und eine erste vordefinierte Länge ($2b_1$) aufweist, die jeweils dem minimalen Radius und der maximalen Länge des interessierenden Bereichs ZI entsprechen,

b) Bestimmen einer letzten Kreiszylinderscheibe (30; 140) der Oz-Achse, die durch letzte Endkreise (30A, 30B; 140A, 140B) begrenzt ist, die erste Kreiszylinderscheibe (10; 110) umgibt und einen letzten vordefinierten Radius ($a_3$; $a_4$) und eine letzte vordefinierte Länge ($2b_3$; $2b_4$) aufweist, die jeweils der maximalen Länge ($2b_1$) und dem minimalern Radius ($a_1$) des interessierenden Bereichs ZI entsprechen,

c) Bestimmen mindestens einer dazwischenliegenden Kreiszylinderscheibe (20; 120, 130) der Oz-Achse, die durch dazwischenliegende Endkreise (20A, 20B; 120A, 120B, 130A, 130B) begrenzt ist, zwischen der ersten Kreiszylinderscheibe (10; 110) und der letzten Kreiszylinderscheibe (30; 140) eingefügt ist und einen vordefinierten dazwischenliegenden Radius ($a_2$; $a_3$), der zwischen dem minimalen Radius ($a_1$) des interessierenden Bereichs und dem letzten vordefinierten Radius ($a_3$; $a_4$) liegt und eine vordefinierte dazwischenliegende Länge ($2b_2$; $2b_3$) aufweist, die zwischen der letzten vordefinierten Länge ($2b_3$; $2b_4$) und der maximalen Länge ($2b_1$) liegt, sodass sich die ersten Endkreise (10A, 1 0B; 110A, 110B), die dazwischenliegenden Endkreise (20A, 20B; 120A, 120B, 130A, 130B) und die letzten Endkreise (30A, 30B; 140A, 140B) auf derselben Kugel mit dem Mittelpunkt O und dem Radius c befinden,

d) Betrachten einer ersten Oberflächenströmungsfläche, die auf der ersten Kreiszylinderscheibe (10; 110) der Oz-Achse gebildet wird, mindestens einer dazwischenliegenden Oberflächenströmungsfläche, die auf der dazwischenliegenden Kreiszylinderscheibe (20; 120, 130) der Oz-Achse gebildet wird und einer letzten schmalen Oberflächenströmungsfläche, die auf der letzten Kreiszylinderscheibe (30; 140) der Oz-Achse gebildet wird, wobei die aufeinanderfolgenden koaxialen Oberflächenströmungsflächen jeweils eine Oberflächendichte $\kappa_i$ der azimutalen Strömung aufweisen, sodass zwei benachbarte koaxiale Oberflächenströmungsflächen Oberflächendichten der azimutalen Strömungen mit entgegengesetzten Vorzeichen aufweisen und Bestimmen der Position der dazwischenliegenden Kreiszylinderscheibe(n) (20; 120, 130), um die Homogenität des Magnetfelds in dem interessierenden Bereich ZI zu verbessern,

e) Ersetzen der aufeinanderfolgenden koaxialen Oberflächenströmungsflächen durch achsensymmetrische schraubenförmige supraleitende Wicklungen (1, 2, 3; 101, 102, 103, 104) mit einem axialen rechteckigen Halbschnitt mit einer Dicke ungleich null, sodass die seitlichen Enden der schraubenförmigen Wicklungen (1, 2, 3; 101, 102, 103, 104), bis auf die Dicke der Wicklungen, in der Nähe derselben Kugel (5; 105) mit einem Radius c angeordnet sind, deren Mittelpunkt O auf der Oz-Achse im Mittelpunkt des interessierenden Bereichs ZI platziert ist und welche die gesamte Magnetvorrichtung umgibt.

4. Verfahren nach Anspruch 3, **dadurch gekennzeichnet, dass** in dem oben genannten Schritt c) eine einzige dazwischenliegende Zylinderscheibe (20) bestimmt wird, in dem oben genannten Schritt d) eine einzige dazwischenliegende Oberflächenströmungsfläche bestimmt wird und in dem oben genannten Schritt e) eine einzige dazwischenliegende achsensymmetrische schraubenförmige supraleitende Wicklung (2) mit einem axialen rechteckigen Halbschnitt mit einer Dicke ungleich null bestimmt wird, welche die einzige dazwischenliegende Oberflächenströmungsfläche ersetzt.

5. Verfahren nach Anspruch 3, **dadurch gekennzeichnet, dass** in dem oben genannten Schritt c) zwei dazwischenliegende Zylinderscheiben (120, 130) bestimmt werden, in dem oben genannten Schritt d) zwei dazwischenliegende Oberflächenströmungsflächen bestimmt werden und in Schritt e) zwei dazwischenliegende achsensymmetrische schraubenförmige supraleitende Wicklungen (102, 103) mit einem axialen rechteckigen Halbschnitt mit einer Dicke ungleich null bestimmt werden, welche die zwei dazwischenliegenden Oberflächenströmungsflächen ersetzen.

**Claims**

1. A compact superconducting magnet device to generate a homogeneous magnetic field component Bz along an axis Oz in a zone of interest (ZI) for nuclear magnetic resonance or magnetic resonance imaging applications, successively comprising, starting from the axis Oz and perpendicular to this axis Oz, at least one first superconducting helical coil (1; 101) formed around a first circular cylinder section (10; 110) of axis Oz delimited by first end circles (10A, 10B; 110A, 110B), said first superconducting helical coil (1; 101) having a first outer radius ($a_{12}$), a first inner radius ($a_{11}$), and a first length ($2b_1$), with a first azimuthal current density $j_1$, at least one second superconducting helical coil (2; 102) formed around a second circular cylinder section (20; 120) of axis Oz delimited by second end circles (20A, 20B; 120A, 120B) and surrounding said first circular cylinder section (10; 110), said second coil (2; 102) having a second outer radius ($a_{22}$), a second inner radius ($a_{21}$) and a second length ($2b_2$), with a second azimuthal current density $j_2$, **characterized in that** the lateral ends of the first and second helical coils (1, 2; 101, 102) are arranged, to within the thickness of the coils, in the vicinity of one same sphere (5; 105) of radius c whose centre O is placed on the axis Oz in the centre of said zone of interest (ZI) and which encompasses the magnet device assembly, **in that** it further comprises at least one third superconducting helical coil (3; 103) formed around a third circular cylinder section (30; 130) of axis Oz delimited by third end circles (30A, 30B; 130A, 130B) and surrounding said second circular cylinder section (20; 120), said third coil (3; 103) having a third outer radius ($a_{32}$), a third inner radius ($a_{31}$) and a third length ($2b_3$), with a third azimuthal current density $j_3$, **in that** said first, second and third azimuthal current densities $j_1$, $j_2$, $j_3$ are of alternate opposite sign, **in that** the first, second and third lengths ($2b_1$, $2b_2$, $2b_3$) of the first, second and third coils (1, 2, 3; 101, 102, 103) are of decreasing length, **in that** the outer radius ($a_{32}$) of the outermost superconducting helical coil (3; 104) is substantially equal to the half-length ($b_1$) of the innermost superconducting helical coil (1; 101) and **in that** the outer radius ($a_{12}$) of the innermost superconducting helical coil (1; 101) is substantially equal to the half-length ($b_3$; $b_4$) of the outermost superconducting helical coil (3; 104), the lateral end of the third coil (3 ; 103) being arranged, to within the thickness of the coil, in the vicinity of the same sphere (5 ; 105) as the one defined for the lateral ends of the first and second coils (1 ; 2 ; 101 ; 102).

2. The magnet device according to claim 1, **characterized in that** it further comprises at least one fourth superconducting helical coil (104) formed around a fourth circular cylinder section (140) of axis Oz delimited by fourth end circles (140A, 140B) and surrounding said third circular cylinder section (130), said fourth superconducting helical coil (104) having a fourth outer radius ($a_{42}$), a fourth inner radius ($a_{41}$) and a fourth length ($2b_4$), with a fourth azimuthal current density $j_4$, **in that** the first, second, third and fourth azimuthal current densities $j_1$, $j_2$, $j_3$, $j_4$ are alternately of opposite sign, and **in that** the first, second, third and fourth lengths ($2b_1$, $2b_2$, $2b_3$, $2b_4$) of the first, second, third and fourth superconducting helical coils (101, 102, 103, 104) are of decreasing length, the lateral end of the forth coil (104) being arranged, to within the thickness of the coil, in the vicinity of the same sphere (105) as the one defined for the lateral ends of said first and second coils (101, 102).

3. A method for producing a compact superconducting magnet device to generate a homogeneous magnetic field component Bz along an axis Oz in a zone of interest ZI for nuclear magnetic resonance or magnetic resonance imaging applications, comprising the following steps:

a. determining a first circular cylinder section (10; 110) of axis Oz delimited by first end circles (10A, 10B; 110A, 110B) and having a first predefined radius ($a_1$) and a first predefined length ($2b_1$) respectively corresponding to the minimum radius and the maximum length of said zone of interest ZI,

b. determining a last circular cylinder section (30; 140) of axis Oz delimited by last end circles (30A, 30B; 140A, 140B), surrounding said first circular cylinder section (10; 110) and having a last predefined radius ($a_3$; $a_4$) and a last predefined length ($2b_3$; $2b_4$) respectively corresponding to the maximum length ($2b_1$) and minimum radius ($a_1$) of said zone of interest ZI,

c. determining at least one intermediate circular cylinder section (20; 120, 130) of axis Oz delimited by intermediate end circles (20A, 20B; 120A, 120B, 130A, 130B), inserted between said first circular cylinder section (10; 110) and said last cylinder section (30; 140), and having an intermediate predefined radius ($a_2$; $a_3$) of between the minimum radius ($a_1$) of said zone of interest and the last predefined radius ($a_3$; $a_4$) and an intermediate predefined length ($2b_2$; $2b_3$) of between said last predefined length ($2b_3$; $2b_4$) and said maximum length ($2b_1$), so that the first end circles (10A, 10B; 110A, 110B), the intermediate end circles (20A, 20B; 120A, 120B, 130A, 130B) and the last end circles (30A, 30B; 140A, 140B) are positioned on one same sphere of centre O and radius c,

d. considering a first surface current sheet formed on the first circular cylinder section (10; 110) of axis Oz, at least one intermediate surface current sheet formed on the intermediate circular cylinder section (20; 120, 130) of axis Oz and a last thin surface current sheet formed on the last circular cylinder section (30; 140) of axis Oz, the successive coaxial surface current sheets each having a surface azimuthal current density $\kappa_j$ such that two adjacent coaxial surface current sheets have surface azimuthal current densities of opposite sign, and determining the location of the intermediate circular cylinder section(s) (20; 120, 130) so as to optimize the homogeneity of the magnetic field in said zone of interest ZI,

e. replacing the successive coaxial surface current sheets by axisymmetric superconducting coils with rectangular axial half-section of nonzero thickness (1, 2, 3; 101, 102, 103, 104) such that the lateral ends of the helical coils (1, 2, 3; 101, 102, 103, 104) are arranged, to within the thickness of the coils, in the vicinity of one same sphere (5; 105) of radius c whose centre O is placed on the axis Oz at the centre of said zone of interest ZI and which encompasses the magnet device assembly.

4. The method according to claim 3, **characterized in that** at aforementioned step c) a single intermediate cylinder section (20) is determined, at aforementioned step d) a single intermediate surface current sheet is determined, and at aforementioned step e) a single intermediate axisymmetric superconducting helical coil (2) is determined with rectangular axial half-section and nonzero thickness replacing the single intermediate surface current sheet.

5. The method according to claim 3, **characterized in that** at aforementioned step c) two intermediate cylinder sections (120, 130) are determined, at aforementioned step d) two intermediate surface current sheets are determined and at aforementioned step e) two intermediate axisymmetric superconducting helical coils (102, 103) are determined with rectangular axial half-section and nonzero thickness replacing said two intermediate surface current sheets.

FIG.1

FIG.2

FIG.3

FIG.4A

FIG.4B

**EP 2 593 804 B1**

## RÉFÉRENCES CITÉES DANS LA DESCRIPTION

**Documents brevets cités dans la description**

- US 20090261246 A1